# EUROPEAN PATENT APPLICATION

(11) **EP 1 657 756 A2**
(43) Date of publication of application: **17.05.2006**
(21) Application number: 05024939.0
(22) Date of filing: 15.11.2005
(51) Int. Cl.: H01L 33/00

(54) **Sheet for optical semiconductor element encapsulation and process for producing optical semiconductor device with the sheet**

(30) Priority: 15.11.2004 JP 2004329887
(71) Applicant: NITTO DENKO CORPORATION, Osaka (JP)
(72) Inventor: Harada, Noriaki c/o Nitto Denko Corporation, Ibaraki-shi Osaka (JP); Hotta, Yuji c/o Nitto Denko Corporation, Ibaraki-shi Osaka (JP); Suehiro, Ichiro c/o Nitto Denko Corporation, Ibaraki-shi Osaka (JP); Sadayori, Naoki c/o Nitto Denko Corporation, Ibaraki-shi Osaka (JP)
(74) Representative: Grünecker, Kinkeldey, Stockmair & Schwanhäusser Anwaltssozietät

(57) **Abstract**

The present invention provides a sheet (1) for optical-semiconductor-element encapsulation, which comprises: an outermost resin layer A (2) that is to be brought into contact with one or more optical semiconductor elements (6); a light-diffusing layer (3) formed on the layer A (2) and containing light-diffusing particles; and a resin layer B (4) formed on the light-diffusing layer (3) and having a lower refractive index than that of the layer A (2). Also disclosed is a process for producing an optical semiconductor device using the sheet (1).

## Description

### FIELD OF THE INVENTION

The present invention relates to a sheet for optical-semiconductor-element encapsulation and a process for producing an optical semiconductor device.

### BACKGROUND OF THE INVENTION

An optical semiconductor device including one or more optical semiconductor elements encapsulated with two or more resin layers is known in which a first encapsulating resin in direct contact with the optical semiconductor elements has been formed by dipping or potting and the resin layers have been disposed such that their refractive indexes are made sequentially smaller, layer by layer, from the optical-semiconductor-element side toward the outermost layer so as to have an improved efficiency of light takeout (see patent document 1).
Patent Document 1: JP-A-10-65220

However, resin encapsulation by dipping or potting has a drawback that the operation of dropping a liquid resin onto individual optical semiconductor elements in a given amount is troublesome. In addition, the encapsulation of optical semiconductor elements with two or more resin layers differing in refractive index is troublesome because it necessitates two or more steps.

### SUMMARY OF THE INVENTION

Accordingly, an object of the invention is to provide a sheet for optical-semiconductor-element encapsulation with which the resin encapsulation of optical semiconductor elements in producing an optical semiconductor device can be easily conducted and which functions to diffuse the directivity of light emitted by the optical semiconductor elements and thereby enables the optical semiconductor device to retain a high efficiency of light takeout.

Another object of the present invention is to provide a process for producing an optical semiconductor device using the sheet.

Other objects and effects of the invention will become apparent from the following description.

Namely, the invention relates to:
[1] A sheet for optical-semiconductor-element encapsulation, which comprises:
   an outermost resin layer A that is to be brought into contact with one or more optical semiconductor elements;
   a light-diffusing layer formed on the layer A and containing light-diffusing particles; and
   a resin layer B formed on the light-diffusing layer and having a lower refractive index than that of the layer A; and
[2] A process for producing an optical semiconductor device which comprises:
   (1) superposing the sheet as described in item [1] above on an optical semiconductor element(s)-mounted side of a wiring circuit board so that the layer A is brought into contact with the optical semiconductor element(s); and
   (2) press-molding the sheet superposed in step (1).

The invention has advantages that the resin encapsulation of optical semiconductor elements in producing an optical semiconductor device can be easily conducted and that the optical semiconductor device obtained can retain a high efficiency of light takeout.

### BRIEF DESCRIPTION OF THE DRAWINGS

Fig. 1 illustrates one embodiment of the sheet for optical-semiconductor-element encapsulation of the invention.
Fig. 2 illustrates one embodiment of step (1) in the process of the invention in which a sheet for optical-semiconductor-element encapsulation is superposed on optical semiconductor elements.
Fig. 3 illustrates one embodiment of step (2) in the process of the invention in which the sheet for optical-semiconductor-element encapsulation is press-molded with a stamper.
Fig. 4 illustrates one embodiment of optical semiconductor devices produced by the process of the invention.

The reference numerals used in the drawings denote the followings, respectively.

1: Sheet for optical-semiconductor-element encapsulation
2: Layer A
3: Light-diffusing layer
4: Layer B
5: Wiring board
6: Optical semiconductor element
7: Stamper

### DETAILED DESCRIPTION OF THE INVENTION

One feature of the sheet for optical-semiconductor-element encapsulation of the invention resides in that it comprises a resin layer (layer A) as the outermost layer on the side to be brought into contact with one or more optical semiconductor elements, a light-diffusing layer formed on the layer A and containing light-diffusing particles, and a resin layer (layer B) formed on the light-diffusing layer and having a lower refractive index than that of the layer A.

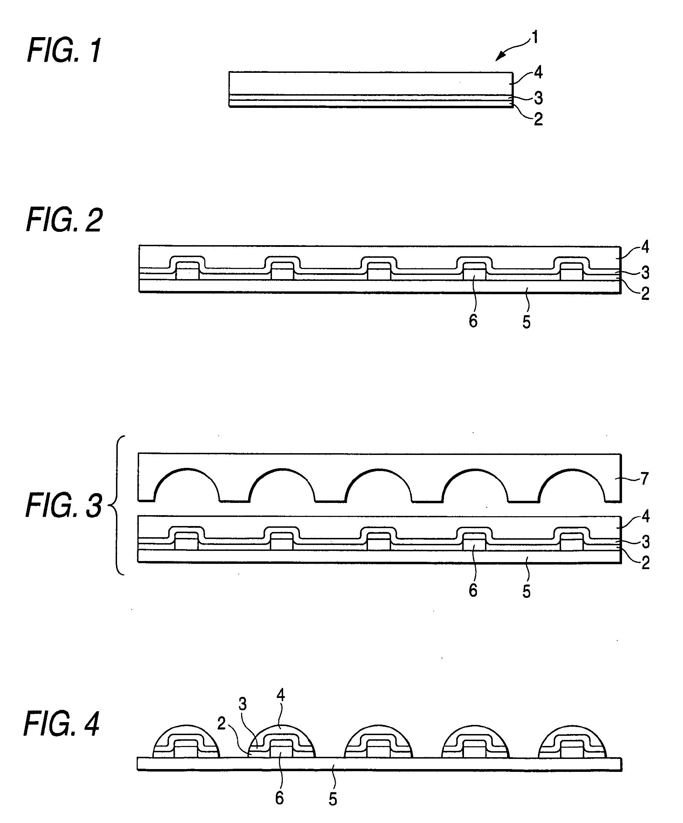

One embodiment of the sheet for optical-semiconductor-element encapsulation 1 of the invention is shown in Fig. 1. This sheet 1 comprises a layer A 2, a light-diffusing layer 3 superposed thereon, and a layer B 4 superposed on the light-diffusing layer 3.

Examples of the resin to be used for forming the layer A 2 include polyethersulfones, polyimides, aromatic polyamides, polycarbodiimides, epoxy resins, and triacetylcellulose. For the encapsulation of optical semiconductor elements, the resin is thermally cured by the method described below. The refractive index of the layer A, i.e., the refractive index of the cured resin, is preferably 1.5 or higher, more preferably 1.5 to 2.1, even more preferably 1.7 to 2.1, from the standpoint of enhancing the efficiency of light takeout from the optical semiconductor elements. The refractive index can be measured by the method described in Production Examples, which will be given below. The refractive index of the layer A can be adjusted to a desired value by appropriately selecting the kind of the resin constituting the layer A, components of the resin, amounts thereof, etc.

Of those resins for use in forming the layer A, polycarbodiimides are preferred because a high refractive index is obtained therewith. More preferred is a polycarbodiimide represented by the following general formula (1): 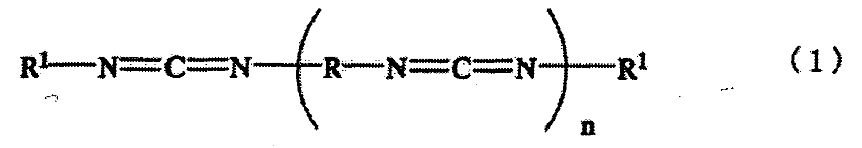 wherein R represents a diisocyanate residue, R¹ represents a monoisocyanate residue, and n is an integer of 1 to 100).

Those resins to be used may be commercial ones. As for the polycarbodiimide, it may be produced, for example, by subjecting one or more diisocyanates to a condensation reaction and blocking the terminals of the resulting polymer with a monoisocyanate in the manner as described below. In formula (1), R represents a residue of the diisocyanate used as a starting material and R¹ represents a residue of the monoisocyanate used as another starting material. The symbol n in general formula (1) is an integer of 1 to 100.

The diisocyanate and monoisocyanate to be used as starting materials may be either aromatic or aliphatic. The diisocyanate and the monoisocyanate each may consist of one or more aromatic isocyanates or one or more aliphatic isocyanates, or may comprise a combination of an aromatic isocyanate and an aliphatic isocyanate. From the standpoint of obtaining a high refractive index, it is preferred to use aromatic isocyanates in the invention. Namely, it is preferred that at least either of the diisocyanate and the monoisocyanate comprises an aromatic isocyanate or consists of one or more aromatic isocyanates, or that each of the diisocyanate and the monoisocyanate consists of one or more aromatic isocyanates. More preferred is the case in which the diisocyanate comprises a combination of an aliphatic isocyanate and an aromatic isocyanate and the monoisocyanate consists of one or more aromatic isocyanates. Especially preferred is the case in which the diisocyanate and the monoisocyanate each consist of one or more aromatic isocyanates.

Examples of diisocyanates usable in the invention include hexamethylene diisocyanate, dodecamethylene diisocyanate, 2,2,4-trimethylhexamethylene diisocyanate, 4,4'-dichlorohexylmethane diisocyanate, xylylene diisocyanate, tetramethylxylylene diisocyanate, isophorone diisocyanate, cyclohexyl diisocyanate, lysine diisocyanate, methylcyclohexane 2,4'-diisocyanate, 4,4'-diphenylmethane diisocyanate, 4,4'-diphenyl ether diisocyanate, 2,6-tolylene diisocyanate, 2,4-tolylene diisocyanate, naphthalene diisocyanate, 1-methoxyphenyl 2,4-diisocyanate, 3,3'-dimethoxy-4,4'-diphenylmethane diisocyanate, 4,4'-diphenyl ether diisocyanate, 3,3'-dimethyl-4,4'-diphenyl ether diisocyanate, 2,2-bis[4-(4-isocyanatophenoxy)phenyl]-hexafluoropropane, and 2,2-bis[4-(4-isocyanatophenoxy)-phenyl]propane.

From the standpoints of obtaining a high refractive index, it is preferred to use as the diisocyanate at least one member selected from the group consisting of tolylene diisocyanate, 4,4'-diphenylmethane diisocyanate, and naphthalene diisocyanate. More preferred is 4,4'-diphenylmethane diisocyanate.

Those diisocyanates can be used singly or as a mixture of two or more thereof.

The one or more diisocyanates to be used as a starting material preferably comprise one or more aromatic diisocyanates in an amount of preferably 10% by mole or larger (upper limit, 100% by mole) based on all diisocyanates. These diisocyanates desirably are ones enumerated above as preferred examples.

Examples of monoisocyanates usable in the invention include cyclohexyl isocyanate, phenyl isocyanate, p-nitrophenyl isocyanate, p- and m-tolyl isocyanates, p-formylphenyl isocyanate, p-isopropylphenyl isocyanate, and 1-naphthyl isocyanate.

Preferred monoisocyanates are aromatic monoisocyanates because aromatic monoisocyanates do not react with each other and the terminal blocking of a polycarbodiimide with such monoisocyanates proceeds efficiently. It is more preferred to use 1-naphthyl isocyanate.

Those monoisocyanates can be used singly or as a mixture of two or more thereof.

The amount of the monoisocyanate to be used for terminal blocking is preferably in the range of 1 to 10 mol per 100 mol of the diisocyanate ingredient to be used. When a monoisocyanate ingredient is used in an amount of 1 mol or larger per 100 mol of the diisocyanate ingredient, the polycarbodiimide obtained neither has too high a molecular weight nor undergoes a crosslinking reaction. Because of this, the polycarbodiimide solution, for example, undergoes neither an increase in viscosity nor solidification nor deterioration in storage stability. Such monoisocyanate ingredient amounts are hence preferred. On the other hand, when a monoisocyanate ingredient is used in an amount of 10 mol or smaller per 100 mol of the diisocyanate ingredient, the resultant polycarbodiimide solution has an appropriate viscosity. Because of this, film formation from the solution can be satisfactorily conducted, for example, through application and drying. Such monoisocyanate ingredient amounts are hence preferred. The polycarbodiimide solution obtained through terminal blocking with a monoisocyanate used in an amount within the above-described range, in terms of the amount thereof relative to the diisocyanate ingredient amount, is excellent especially in storage stability.

The polycarbodiimide for use in the invention can be produced by converting one or more diisocyanates as a starting material to a carbodiimide through condensation reaction in a predetermined solvent in the presence of a catalyst for carbodiimide formation and blocking the terminals of the resultant carbodiimide polymer with a monoisocyanate.

The diisocyanate condensation reaction is conducted at a temperature of generally 0 to 150°C, preferably 10 to 120°C.

In the case where an aliphatic diisocyanate and an aromatic diisocyanate are used in combination as starting-material diisocyanates, it is preferred to react the diisocyanates at a low temperature. The reaction temperature is preferably 0 to 50°C, more preferably 10 to 40°C. Use of a reaction temperature in this range is preferred because the condensation of the aliphatic diisocyanate with the aromatic diisocyanate proceeds sufficiently.

In the case where the excess aromatic diisocyanate present in the reaction mixture is desired to be further reacted with the polycarbodiimide formed from an aliphatic diisocyanate and an aromatic diisocyanate, the reaction temperature is preferably 40 to 150°C, more preferably 50 to 120°C. As long as the reaction temperature is within this range, any desired solvent can be used to smoothly conduct the reaction. The above reaction temperature range is therefore preferred.

The diisocyanate concentration in the reaction mixture is preferably 5 to 80% by weight. As long as the diisocyanate concentration is within this range, carbodiimide formation proceeds sufficiently and reaction control is easy. The above diisocyanate concentration range is therefore preferred.

Terminal blocking with a monoisocyanate can be accomplished by adding the monoisocyanate to the reaction mixture in an initial, middle, or final stage of carbodiimide formation from the diisocyanate(s) or throughout the carbodiimide formation. The monoisocyanate is preferably an aromatic monoisocyanate.

As the catalyst for carbodiimide formation, any of known phosphorus compound catalysts can be advantageously used. Examples thereof include phospholene oxides such as 1-phenyl-2-phospholene 1-oxide, 3-methyl-2-phospholene 1-oxide, 1-ethyl-2-phospholene 1-oxide, 3-methyl-1-phenyl-2-phospholene 1-oxide, 3-methyl-1-phenyl-2-phospholene 2-oxide, and the 3-phospholene isomers of these.

The solvent (organic solvent) to be used for producing the polycarbodiimide is a known one. Examples thereof include halogenated hydrocarbons such as tetrachloroethylene, 1,2-dichloroethane, and chloroform, ketone solvents such as acetone, methyl ethyl ketone, methyl isobutyl ketone, and cyclohexanone, cyclic ether solvents such as tetrahydrofuran and dioxane, and aromatic hydrocarbon solvents such as toluene and xylene. These solvents can be used singly or as a mixture of two or more thereof. These solvents may be used also for dissolving the obtained polycarbodiimide.

The end point of the reaction can be ascertained by infrared spectroscopy (IR analysis) from the occurrence of absorption attributable to the carbodiimide structure (N=C=N) (2,135 cm⁻¹) and the disappearance of absorption attributable to the isocyanates (2,270 cm⁻¹).

After completion of the carbodiimide-forming reaction, a polycarbodiimide is obtained usually in the form of a solution. However, the solution obtained may be poured into a poor solvent such as methanol, ethanol, isopropyl alcohol, or hexane to precipitate the polycarbodiimide and remove the unreacted monomers and the catalyst.

In preparing a solution of the polycarbodiimide which has been recovered as a precipitate, the precipitate is washed and dried in a predetermined manner and then dissolved again in an organic solvent. By performing this operation, the polycarbodiimide solution can have improved storage stability.

In the case where the polycarbodiimide solution contains by-products, the solution may be purified, for example, by adsorptively removing the by-products with an appropriate adsorbent. Examples of the adsorbent include alumina gel, silica gel, activated carbon, zeolites, activated magnesium oxide, activated bauxite, Fuller's earth, activated clay, and molecular sieve carbon. These adsorbents can be used singly or in combination of two or more thereof.

By the method described above, a polycarbodiimide is obtained. This polycarbodiimide is preferably one in which the backbone structure is constituted of aromatic and aliphatic diisocyanates and the terminals have been blocked with an aromatic monoisocyanate. More preferred is one in which the backbone structure is constituted of one or more aromatic diisocyanates and the terminals have been blocked with an aromatic monoisocyanate.

Specifically, the polycarbodiimide is preferably one in which 10% by mole or more (upper limit, 100% by mole) of the diisocyanate residues represented by R in general formula (1) are residues of one or more aromatic diisocyanates and the monoisocyanate residues represented by R¹ in general formula (1) are residues of one or more aromatic monoisocyanates. The aromatic diisocyanate residues are preferably residues of at least one member selected from the group consisting of tolylene diisocyanate, 4,4'-diphenylmethane diisocyanate, and naphthalene diisocyanate, and more preferably are 4,4'-diphenylmethane diisocyanate residues. The aromatic monoisocyanate residues are preferably 1-naphthyl isocyanate residues.

The refractive index of the layer A which comprises the polycarbodiimide thus obtained is preferably 1.5 to 2.1.

The layer A may be a resin layer containing an inorganic oxide, such as titanium oxide or zirconium oxide, dispersed therein for the purpose of adjusting the refractive index of the layer A.

The layer A is obtained, for example, by dissolving the resin in an organic solvent such as toluene, cyclohexanone, or methyl ethyl ketone preferably in such an amount as to result in a concentration of 20 to 50% by weight to prepare a resin solution, forming the resin solution into a film having an appropriate thickness on, e.g., a release sheet having a silicone-treated surface (e.g., PET separator) by a technique such as casting, spin coating, or roll coating, and then drying the film at such a temperature that the solvent can be removed without causing a curing reaction to proceed. The temperature at which the resin solution formed into a film is dried cannot be unconditionally determined because it varies depending on the kinds of the resin and solvent. However, the temperature is preferably 20 to 350°C, more preferably 50 to 250°C, particularly preferably 70 to 200°C. The thickness of the resin layer obtained through drying with heating is preferably 2 to 50 µm, more preferably 5 to 30 µm, when followability to optical semiconductor elements is taken into account.

Examples of the resin for forming the light-diffusing layer 3 include the same resins as those enumerated above with regard to the layer A. The resin is preferably of the same kind as the resin constituting the resin layer which is adjacent to the light-diffusing layer and which is disposed on the optical-semiconductor-element side. For the encapsulation of optical semiconductor elements, this resin is thermally cured in the manner described below. In this specification, the light-diffusing layer is clearly distinguished from the "resin layers", and the refractive index of the resin in the light-diffusing layer may be lower or higher than or the same as the refractive index of each of the resin layers including the layers A and B.

Examples of the light-diffusing particles contained in the light-diffusing layer include inorganic oxides such as silica, zinc oxide, alumina, titanium oxide, and zirconium oxide. From the standpoints of dispersibility and the ease of particle diameter regulation, silica is preferred of these. These particulate light-diffusing materials may be used in combination of two or more thereof. Furthermore, a fluorescent material which converts the light emitted by a blue LED or purple LED to white light may be used as the light-diffusing particles. The particle diameter of the light-diffusing particles is preferably from 500 nm to 10 µm, more preferably from 500 nm to 1 µm, from the standpoint of maintaining light-diffusing properties and light transmission. The content of the light-diffusing particles in the light-diffusing layer is preferably 10 to 50% by volume, more preferably 10 to 30% by volume, from the standpoints of light-diffusing properties and light transmission.

The light-diffusing layer can be obtained by preparing a resin solution in the same manner as for the layer A, adding light-diffusing particles to this resin solution preferably in an amount of 10 to 50% by volume on a solid basis after drying, mixing the ingredients with stirring, and then performing subsequent steps in the same manner as for the layer A. The thickness of this light-diffusing layer obtained through drying with heating is preferably 1 to 50 µm, more preferably 10 to 40 µm, when followability to optical semiconductor elements, light-diffusing properties, and light transmission are taken into account.

Examples of the resin to be used for forming the layer B 4 include the same resins as those enumerated above with regard to the layer A. For the encapsulation of optical semiconductor elements, this resin is thermally cured in the manner described below. The refractive index of the layer B, i.e., the refractive index of the cured resin, is not particularly limited as long as it is lower than the refractive index of the layer A. However, from the standpoint of enhancing the efficiency of light takeout from optical semiconductor elements, the refractive index of the layer B is preferably 1.1 to 1.5, more preferably 1.3 to 1.5. The refractive index can be measured by the method described in Production Examples, which will be given below. The refractive index of the layer B can be adjusted to a desired value by appropriately selecting the kind of the resin constituting the layer B, components of the resin, amounts thereof, etc.

Of the resins usable for forming the layer B, epoxy resins are preferred from the standpoints of the ease of molding and low cost. For the purpose of adjusting the refractive index of the layer B, an inorganic oxide such as titanium oxide or zirconium oxide may be dispersed in this resin layer. Furthermore, a transparent rubber or elastomer which does not inhibit the transmission of visible light may be incorporated for the purpose of improving the flexibility of the layer B.

The resin layer constituting the layer B can be obtained in the same manner as for the layer A. The temperature at which the resin solution formed into a film is dried cannot be unconditionally determined because it varies depending on the kinds of the resin and solvent. However, the temperature is preferably 20 to 180°C, more preferably 50 to 150°C, particularly preferably 70 to 120°C. The thickness of the layer B obtained through drying with heating is preferably 25 to 500 µm, more preferably 50 to 300 µm, when followability to optical semiconductor elements is taken into account. The resin layer thus obtained may be used as the layer B. Alternatively, a laminate of two or more such resin layers may be used as the layer B.

Besides the above-described layer A, light-diffusing layer and layer B, the sheet for optical-semiconductor-element encapsulation of the invention may further comprises one or more resin layers. In this case, examples of the resins to be used for forming these optional resin layers include the same resins as those enumerated above with regard to the layer A. It is preferred that the resin layers constituting the sheet have refractive indexes that are decreasing, layer by layer, from the layer A toward the layer B. In this case, each one light-diffusing layer as describe above may be disposed between every adjacent two resin layers. It is, however, preferred from the standpoint of transmission that one sheet for optical-semiconductor-element encapsulation has one light-diffusing layer.

The sheet for optical-semiconductor-element encapsulation of the invention is produced, for example, by separately forming the layer A, light-diffusing layer, and layer B and other resin layers and then laminating the layer A, light-diffusing layer, layer B, and other resin layers by a known technique (e.g., laminating with heating/pressing, vacuum laminating, or vacuum pressing). When the efficiency of light takeout and the trouble of layer superposition are taken into account, the sheet for optical-semiconductor-element encapsulation of the invention preferably comprises two to five resin layers and one light-scattering layer, and more preferably comprises two resin layers and one light-diffusing layer. The thickness of the sheet thus obtained is preferably about 150 to 300 µm when the height of optical semiconductor elements and molding with a stamper are taken into account.

A preferred combination of the layer A and the layer B in the invention is one in which the layer A is a polycarbodiimide layer and the layer B is an epoxy resin layer, from the standpoints of the efficiency of light takeout and the ease of molding.

The process for producing an optical semiconductor device with the sheet for optical-semiconductor-element encapsulation of the invention obtained by the method described above will be explained below.

One major feature of the process of the invention for producing an optical semiconductor device resides in that the process comprises:
(1) superposing the sheet for optical-semiconductor-element encapsulation obtained above on an optical semiconductor element(s)-mounted side of a wiring circuit board so that the layer A is brought into contact with the optical semiconductor element(s); and
(2) press-molding the sheet superposed in step (1).

Examples of the step of superposing the sheet for optical-semiconductor-element encapsulation of the invention on that side of a wiring circuit board on which one or more optical semiconductor elements have been mounted include a method in which the sheet of the invention (sheet comprising a layer A 2, light-diffusing layer 3, and layer B which have been superposed in this order) is laminated by means of, e.g., a laminator onto a wiring circuit board 5 having optical semiconductor elements 6 mounted thereon, as shown in Fig. 2.

The optical semiconductor elements 6 to be used in the invention are not particularly limited as long as they are ones for ordinary use in optical semiconductor devices. Examples thereof include gallium nitride (GaN; refractive index, 2.5), gallium phosphide (GaP; refractive index, 2.9), and gallium arsenide (GaAs; refractive index, 3.5). GaN is preferred of these, because it emits blue light and a white LED can be produced when a fluorescent material is used therewith.

The wiring circuit board 5 on which optical semiconductor elements are to be mounted also is not particularly limited. Examples thereof include rigid wiring boards produced by superposing a copper wiring on a glass-epoxy substrate and flexible wiring boards produced by superposing a copper wiring on a polyimide film.

Examples of methods for mounting optical semiconductor elements 6 on the wiring circuit board 5 include: a face-up bonding method, which is suitable for mounting optical semiconductor elements having an electrode disposed on the light emission side; and a flip chip bonding method, which is suitable for mounting optical semiconductor elements having an electrode disposed on the side opposite to the light emission side.

In the case where the sheet of the invention is melted and laminated onto the wiring circuit board by press bonding with heating by means of a laminator or the like, it is preferred that the sheet be heated at preferably 70 to 250°C, more preferably 100 to 200°C, and pressed at preferably 0.1 to 10 MPa, more preferably 0.5 to 5 MPa. In the case of using a laminator, the rotation speed thereof is preferably 100 to 2,000 rpm, more preferably 500 to 1,000 rpm.

Subsequently, the resultant structure is subjected to step (2). A major feature of the invention resides also in step (2). Since the resin layers differing in refractive index can be press-molded at a time, an optical semiconductor device can be easily produced without impairing the efficiency of light takeout of the optical semiconductor device.

The press molding of the sheet can be conducted with a stamper or the like. In the invention, the stamper to be used can be, for example, one obtained by forming a polyimide sheet or polycarbonate sheet into a predetermined shape die by laser processing or one obtained by plating such a die as a master (original) with a metal, e.g., nickel.

The press molding of the sheet with a stamper can be conducted, for example, in the following manner. The stamper 7 is aligned so that a resin layer having recesses or protrusions can be formed over the optical semiconductor elements 6 as shown in Fig. 3. This assemblage is inserted into the space between a heated pressing plate and the other heated pressing plate and heated/pressed, whereby the sheet formed in step (1) can be thermally cured and molded as shown in Fig. 4.

Examples of the conditions for the heating/pressing include a temperature for the heating of preferably 70 to 250°C, more preferably 100 to 200°C, a pressure for the pressing of preferably 0.1 to 10 MPa, more preferably 0.5 to 5 MPa, and a period of this heating/pressing of preferably from 5 seconds to 3 minutes, more preferably from 10 seconds to 1 minute.

By molding the resin layers on the optical semiconductor elements into a shape having recesses or protrusions, light regulation and an improvement in the efficiency of light takeout can be attained due to the resultant lenses.

By superposing the sheet, which comprises resin layers differing in refractive index and further has a light-diffusing layer interposed between these, onto a wiring circuit board and press-molding the resin layers on the optical semiconductor elements with a stamper or the like as in the invention, the resin encapsulation of the optical semiconductor elements can be accomplished without impairing the efficiency of light takeout.

### EXAMPLES

The present invention will be illustrated in greater detail with reference to the following Examples, but the invention should not be construed as being limited thereto.

In the following Examples, all the synthesis reactions were conducted in a nitrogen stream. IR analysis was made with FT/IR-230 (manufactured by JEOL Ltd.).

### PRODUCTION EXAMPLE 1

### Production of Polycarbodiimide Sheet

Into a 500-mL four-necked flask equipped with a stirrer, dropping funnel, reflux condenser, and thermometer were introduced 98.85 g (395 mmol) of 4,4' -diphenylmethane diisocyanate, 0.38 g (1.975 mmol) of 3-methyl-1-phenyl-2-phospholene 1-oxide, and 191.18 g of cyclohexanone. The resultant mixture was held at 40°C with stirring for 1 hour. The progress of a reaction was ascertained by IR analysis, and 10.02 g (59.25 mmol) of 1-naphthyl isocyanate was added. This mixture was heated to 100°C with stirring.

The progress of reactions was ascertained by IR analysis in the following manner. The decrease in the amount of absorption by N=C=O stretching vibration attributable to the isocyanates (2,270 cm⁻¹) and the increase in the amount of absorption by N=C=N stretching vibration attributable to carbodiimide (2,135 cm⁻¹) were followed. After the end point of the reactions was ascertained by IR analysis, the reaction mixture was cooled to room temperature. Thus, a polycarbodiimide solution was obtained in an amount of 300.43 g. This polycarbodiimide was one represented by general formula (1) given above wherein n had a distribution of from 1 to 83.

Subsequently, the polycarbodiimide solution was applied with a coater to a separator (thickness, 50 µm) (manufactured by Mitsubishi Polyester Film Corp.) made of a poly(ethylene terephthalate) film treated with a release agent (fluorinated silicone) (coating speed: 1 m/min). The resultant coating was heated at 110°C for 1 minute and then at 130°C for 1 minute. Thereafter, the separator was removed to obtain a temporarily cured polycarbodiimide in a sheet form (thickness, 15 µm).

The sheet-form polycarbodiimide obtained was cured in a 150°C curing oven, and the refractive index of the resultant cured resin was measured at 25°C with a multi-wavelength Abbe's refractometer (DR-M4, manufactured by ATAGO) at a wavelength of 589 nm. The refractive index of the cured resin was found to be 1.715.

### PRODUCTION EXAMPLE 2

### Production of Sheet for Light Diffusion

A silica filler (SE-2050TA, manufactured by Admatechs Co., Ltd.) was mixed with the polycarbodiimide solution prepared in Production Example 1, in an amount of 80 g on a dry basis per 100 g of the polycarbodiimide on a solid basis. The filler was evenly dispersed with a stirrer to prepare a dispersion. This silica filler amount on a dry basis corresponds to 28.6% by volume of the polycarbodiimide solution.

Subsequently, the dispersion was applied with a coater to a separator (thickness, 50 µm) (manufactured by Mitsubishi Polyester Film Corp.) made of a poly(ethylene terephthalate) film treated with a release agent (fluorinated silicone) (coating speed: 1 m/min). The resultant coating was heated at 110°C for 1 minute and then at 130°C for 1 minute. Thereafter, the separator was removed to obtain a temporarily cured sheet for light diffusion (thickness, 20 µm).

### PRODUCTION EXAMPLE 3

### Production of Epoxy Resin Sheet

To 200 g of methyl ethyl ketone (MEK) was gradually added 200 g of a powder of an epoxy resin (NT-8528, manufactured by Nitto Denko Corp.) with stirring at 50°C. The resin was completely dissolved to prepare a resin solution having a solid concentration of 50 wt%. The resin solution obtained was applied to a separator (thickness, 50 µm) (manufactured by Mitsubishi Polyester Film Corp.) made of a poly(ethylene terephthalate) film treated with a release agent (fluorinated silicone). The resultant coating was heated at 100°C for 2 minutes and then at 120°C for 2 minutes. Thereafter, the separator was removed to obtain a temporarily cured epoxy resin in a sheet form (thickness, 50 µm).

The sheet-form epoxy resin obtained was cured in a 120°C curing oven, and the refractive index of the resultant cured resin was measured at 25°C with a multi-wavelength Abbe's refractometer (DR-M4, manufactured by ATAGO) at a wavelength of 589 nm. The refractive index of the cured resin was found to be 1.520.

### EXAMPLE 1

Three sheets of the temporarily cured sheet-form epoxy resin obtained in Production Example 3 were stacked up with a hot laminator (NLE-550ST, manufactured by Nitto Seiki Inc.) at 100°C and 1,500 rpm to produce a layer B having a thickness of 150 µm. The sheet for light diffusion obtained in Production Example 2 was superposed as a light-diffusing layer on the layer B with the hot laminator (NLE-550ST, manufactured by Nitto Seiki Inc.) at 100°C and 1,500 rpm. Furthermore, the temporarily cured sheet-form polycarbodiimide obtained in Production Example 1 was superposed as a layer A on the light-diffusing layer with the hot laminator (NLE-550ST, manufactured by Nitto Seiki Inc.) at 100°C and 1,500 rpm. Thus, a sheet for optical-semiconductor-element encapsulation of the invention was produced which had a thickness of 185 µm.

This sheet was laminated onto a wiring circuit board having optical semiconductor elements comprising GaN mounted thereon, with a vacuum laminator (V-130, manufactured by Nichigo-Morton Co., Ltd.) so that the layer A came into contact with the optical semiconductor elements.

Subsequently, a stamper (made of polyimide) having 15-µm diameter recesses with a depth of 30 µm was used to press-mold the resultant laminate at 150°C and 0.1 MPa for 60 seconds in such a manner that the laminate was held under vacuum for 30 seconds. Thus, an optical semiconductor device was produced.

### COMPARATIVE EXAMPLE 1

A sheet for optical-semiconductor-element encapsulation was produced in the same manner as in Example 1, except that the sheet for light diffusion was not used. This sheet for optical-semiconductor-element encapsulation was used to produce an optical semiconductor device in the same manner as in Example 1.

### COMPARATIVE EXAMPLE 2

The polycarbodiimide solution was applied with a spin coater onto a wiring circuit board having optical semiconductor elements mounted thereon to thereby form a layer A. Subsequently, molds for encapsulation were placed on the circuit board and a liquid epoxy resin was poured into the molds. These molds were covered and the epoxy resin was cured at 120°C for 12 hours to thereby produce an optical semiconductor device.

### TEST EXAMPLE

A voltage was applied to the optical semiconductor devices obtained in Example 1 and Comparative Examples 1 and 2 to measure the quantity of light emitted by each device. In this light quantity measurement, the quantity of overall light emitted was measured with MCPD-3000 (manufactured by Otsuka Electronics Co., Ltd.) using an integrating sphere. The results obtained are shown in Table 1.

**Table 1**

| | Quantity of light emitted (µW/cm²/nm) |
|---|---|
| Example 1 | 1.2 |
| Comparative Example 1 | 1.0 |
| Comparative Example 2 | 0.97 |

The results given above show the following. The optical semiconductor device obtained in Example 1 emitted a larger quantity of light than the optical semiconductor device obtained in Comparative Example 1 and hence had a high efficiency of light takeout. Furthermore, Comparative Example 2 necessitated the disposition of an encapsulation mold and resin casting therein with respect to each of the optical semiconductor elements. Namely, the production steps in Comparative Example 2 were troublesome as compared with those in Example 1.

The optical semiconductor device produced by the invention is useful in applications such as surface light sources for personal computers, cell phones, etc.

While the present invention has been described in detail and with reference to specific embodiments thereof, it will be apparent to one skilled in the art that various changes and modifications can be made therein without departing from the spirit and scope thereof.

This application is based on Japanese Patent Application No. 2004-329887, the contents thereof being herein incorporated by reference.

## Claims

1. A sheet for optical-semiconductor-element encapsulation, which comprises:
an outermost resin layer A that is to be brought into contact with one or more optical semiconductor elements;
a light-diffusing layer formed on the layer A and containing light-diffusing particles; and
a resin layer B formed on the light-diffusing layer and having a lower refractive index than that of the layer A.

2. The sheet of claim 1, further comprising one or more resin layers between the layer A and the layer B,
wherein the resin layers constituting the sheet have refractive indexes that are decreasing, layer by layer, from the layer A toward the layer B.

3. The sheet of claim 1 or 2, wherein the light-diffusing particles comprise at least one inorganic oxide.

4. The sheet of any one of claims 1 to 3, wherein the light-diffusing particles have a particle diameter of from 500 nm to 10 µm.

5. The sheet of any one of claims 1 to 4, wherein the layer A comprises a polycarbodiimide.

6. The sheet of any one of claims 1 to 5, wherein the light-diffusing layer comprises a polycarbodiimide and the light-diffusing particles contained therein.

7. The sheet of any one of claims 1 to 6, wherein the light-diffusing layer has a thickness of 1 to 50 µm.

8. The sheet of any one of claims 1 to 7, wherein the content of the light-diffusing particles in the light-diffusing layer is 10 to 50% by volume.

9. A process for producing an optical semiconductor device, which comprises:
(1) superposing the sheet of any one of claims 1 to 8 on an optical semiconductor element(s)-mounted side of a wiring circuit board so that the layer A is brought into contact with the optical semiconductor element(s); and
(2) press-molding the sheet superposed in step (1).
